# EUROPEAN PATENT APPLICATION

(11) **EP 3 664 159 A1**
(43) Date of publication of application: **10.06.2020**
(21) Application number: 18306604.2
(22) Date of filing: 03.12.2018
(51) Int. Cl.: H01L 31/0304, H01L 31/0725, H01L 31/0735, H01L 31/075, H01L 31/076, H01L 31/043, H01L 31/18

(54) **PHOTOVOLTAIC CELL WITH AN ALUMINIUM-ARSENIC AND INDIUM-PHOSPHOROUS BASED HETEROJUNCTION, ASSOCIATED MULTI-JUNCTION CELL AND ASSOCIATED METHOD**

(71) Applicant: Institut Photovoltaique d'Ile de France, 91120 Palaiseau (FR); CENTRE NATIONAL DE LA RECHERCHE SCIENTIFIQUE, 75016 Paris (FR); Electricité de France, 75008 Paris (FR); Total SA, 92400 Courbevoie (FR); Riber, 95870 Bezons (FR)
(72) Inventor: BEN SLIMANE, Ahmed, 91120 Palaiseau (FR)
(74) Representative: Croonenbroek, Thomas Jakob

(57) **Abstract**

The present invention refers to a photovoltaic cell (1) comprising a heterojunction with a base layer (L4, L4', L4") made from an Aluminium-Arsenic-based alloy and an emitter layer (L3, L3') made from an Indium-Phosphorous based alloy wherein the emitter layer (L3, L3') has a thickness smaller than 100 nm and acts as a passivation layer to prevent oxidation of the base layer and reduces surface recombination (L4, L4', L4").

## Description

### Background of the invention

The present invention refers to photovoltaic energy production and in particular high efficiency photovoltaic cells enabling the conversion of the solar energy into electricity.

With climate change, global warming and the fossil fuel depletion, many technologies have been developed over the past few years in order to use alternate resources and in particular renewable energy resources.

One of the main technologies refers to the use of photovoltaic cells to convert the solar energy into electricity.

A solar cell comprises a P-N junction wherein light is absorbed to create electron-hole pairs and opposite electrodes to collect electrons on one side and holes on the other side.

In order to improve the efficiency of the photovoltaic cells, one way is to stack two photovoltaic cells having different bandgap to form a tandem photovoltaic cell wherein each photovoltaic cell will convert a different part of the spectrum of the received light.

The tandem photovoltaic cells usually comprise a back photovoltaic cell based on Silicon and having a bandgap around 1.1 eV.

The front photovoltaic cell needs to have a higher bandgap, preferably around 1.7 eV.

AlGaAs alloys are good candidates for front photovoltaic cell of a Silicon based tandem photovoltaic cell as they offer a tunable bandgap from 1.42 eV to 2.16 eV depending on the Aluminium concentration and lattice constants matching the GaAs used for the growth substrate and back contact of the front cell.

However, AlGaAs alloys have also drawbacks, in particular their poor oxidation resistance leading to aluminium-oxygen deep level contaminations producing a reduced minority carrier diffusion length and leading to a poor efficiency.

Another candidate providing a higher oxidation resistance is the InGaP which has a bandgap around 1.9 eV with a relatively good radiation hardness and a low interface recombination rate. Despite these good material properties, such solution is not yet preferred due to the rareness and the cost of the Indium element.

The present invention aims therefore at providing a solution to obtain a photovoltaic cell providing a bandgap close to 1.7 eV, having a good resistance against oxidation contaminants and a reduced manufacturing cost.

### Summary of the invention

The present invention refers to a photovoltaic cell comprising a heterojunction with a base layer made from an Aluminium-Arsenic-based alloy and an emitter layer made from an Indium-Phosphorous based alloy wherein the emitter layer has a thickness smaller than 100 nm and acts as a passivation layer to prevent oxidation of the base layer.

According to another aspect of the present invention, the heterojunction is a p-i-n heterojunction and comprises at least one intrinsic sub-layer at the interface between the base layer and the emitter layer.

According to a further aspect of the present invention, the base layer is made of an Aluminium-Gallium-Arsenic "AlGaAs" alloy.

According to an additional aspect of the present invention, the emitter layer is made of an Indium-Gallium-Phosphide "InGaP" alloy.

According to another aspect of the present invention, the base layer comprises a graded Aluminium based alloy with an Aluminium percentage composition varying in a range from 20 to 55%.

According to a further aspect of the present invention, the base layer comprises a first sublayer made of AlGaAs with 25% of Aluminium doped with Beryllium and a second sub-layer made of an intrinsic graded AlGaAs with a percentage of Aluminium composition varying from 25 to 30%.

According to an additional aspect of the present invention, the base layer has a bandgap of 1.7 eV and the emitter layer has a bandgap of 1.9 eV.

According to another aspect of the present invention, the photovoltaic cell also comprises
- a front contact layer made of Gallium-Arsenic "GaAs" alloy doped with one among the following dopants:
   - Silicon "Si",
   - Selenium "Se",
   - Tellurium "Te",
   with a doping concentration comprised between 5.10¹⁸ cm⁻³ and 5.10¹⁹ cm⁻³ and having a thickness comprised between 150 nm and 300 nm,
- a window layer made of Aluminium-Indium-Phosphide "AlInP" alloy doped with one among the following dopants:
   - Silicon "Si",
   - Selenium "Se",
   - Tellurium "Te",
   with a doping concentration comprised between 5.10¹⁸ cm⁻³ and 1.10¹⁹ cm⁻³ and having a thickness comprised between 20 nm and 70 nm,
- an emitter layer made of Indium-Gallium-Phosphide "InGaP" alloy which can be doped with one among the following dopants:
   - Silicon "Si",
   - Selenium "Se",
   - Tellurium "Te",
   with a doping concentration comprised between 1.10¹⁶ cm⁻³ and 2.10¹⁸ cm⁻³
   and having a thickness comprised between 20 nm and 100 nm,
- a base layer made of Aluminium-Gallium-Arsenic "AlₓGa₁₋ₓAs" alloy with x comprised between 0 and 0.37 and doped with one among the following dopants:
   - Beryllium "Be",
   - Carbon "C",
   - Zinc "Zn",
   with a doping concentration comprised between 2.10¹⁶ cm⁻³ and 5.10¹⁷ cm⁻³ and having a thickness comprised between 200 nm and 2000 nm,
- a back surface field made of Aluminium-Gallium-Arsenic "AlₓGa₁₋ₓAs" alloy with x comprised between 0.4 and 0.8 and doped with one among the following dopants:
   - Beryllium "Be",
   - Carbon "C",
   - Zinc "Zn",
   with a doping concentration comprised between 5.10¹⁸ cm⁻³ and 1.10¹⁹ cm⁻³ and having a thickness comprised between 20 nm and 120 nm,
- a back contact layer made of Gallium-Arsenic "GaAs" alloy doped with one among the following dopants:
   - Beryllium "Be",
   - Carbon "C",
   - Zinc "Zn",
with a doping concentration comprised between 5.10¹⁸ cm⁻³ and 1.10¹⁹ cm⁻³ and having a thickness comprised between 150 nm and 300 nm.

According to a further aspect of the present invention, the photovoltaic cell comprises:
- a front contact layer made of Gallium-Arsenic "GaAs" alloy doped with Silicon "Si"
   with a doping concentration comprised between 5.10¹⁸ cm⁻³ and 2.10¹⁹ cm⁻³ and having a thickness comprised between 150 and 320 nm,
- a window layer made of Aluminium-Indium-Phosphide "AlInP" alloy doped with Silicon "Si" with a doping concentration comprised between 5.10¹⁸ cm⁻³ and 2.10¹⁹ cm⁻³ and having a thickness comprised between 20 nm and 50 nm,
- an undopped emitter layer made of Indium-Gallium-Phosphide "InGaP" having a thickness comprised between 40 and 60 nm,
- a base layer made of Aluminium-Gallium-Arsenic "Al_{0.25}GaAs" alloy doped with Beryllium "Be" with a doping concentration comprised between 1.10¹⁶ cm⁻³ and 2.10¹⁷ cm⁻³ and having a thickness comprised between 400 nm and 2000 nm,
- a back surface field made of Aluminium-Gallium-Arsenic "Al_{0.51}GaAs" alloy doped with Beryllium "Be" with a doping concentration comprised between 4.10¹⁸ cm⁻³ and 1.10¹⁹ cm⁻³ and having a thickness comprised between 20 nm and 80 nm,
- a back contact layer made of Gallium-Arsenic "GaAs" alloy doped with Beryllium "Be", with a doping concentration comprised between 5.10¹⁸ cm⁻³ and 2.10¹⁹ cm⁻³
and having a thickness comprised between 150 nm and 300 nm.

According to an additional aspect of the present invention, the base layer also comprises:
- a front additional sub-layer (L41) made of undoped Aluminium-Gallium-Arsenic "AlₓGa₁₋ₓAs" with a graded concentration of Aluminium varying between 25% and 37% and having a thickness comprised between 80 and 120 nm,
- a back additional sub-layer (L43) made of Aluminium-Gallium-Arsenic "AlₓGa₁₋ₓAs" with a graded concentration of Aluminium varying between 25% and 51% and doped with Beryllium "Be" with a doping concentration comprised between 4.10¹⁸ cm⁻³ and 6.10¹⁸ cm⁻³ and having a thickness comprised between 80 and 120 nm.

According to another aspect of the present invention, the back contact layer also comprises:
- a front additional sub-layer (L61) made of Aluminium-Gallium-Arsenic "AlₓGa₁₋ₓAs" with a graded concentration of Aluminium varying between 51% and 0% and doped with Beryllium "Be" with a doping concentration comprised between 4.10¹⁸ cm⁻³ and 6.10¹⁸ cm⁻³ and having a thickness comprised between 80 and 120 nm.

The present invention also refers to a multi-junction photovoltaic cell comprising a stack of at least a first and a second photovoltaic cells, with a front photovoltaic cell having a first bandgap and a second photovoltaic cell having a second bandgap lower than the first bandgap wherein at least the front photovoltaic cell is a photovoltaic cell as described previously.

According to another aspect of the present invention, the multi-junction photovoltaic cell comprises two photovoltaic cells wherein the second photovoltaic cell is a silicon-based cell having a bandgap of 1.1 eV.

The present invention also refers to a method for manufacturing a photovoltaic cell or a tandem photovoltaic cell as described previously wherein at least some of the layers of the tandem photovoltaic cell are obtained based on a molecular beam epitaxy "MBE" process or a Metalorganic Chemical Vapor Deposition "MOCVD" process.

### Brief description of the drawings

[Fig.1] is a diagram of the different layers of a photovoltaic cell according to a first embodiment of the invention;
[Fig.2] is a diagram of the different layers of a photovoltaic cell according to a second embodiment of the invention;
[Fig.3] is a diagram of the different layers of a photovoltaic cell according to a third embodiment of the invention;
[Fig.4] is a diagram of the different layers of a photovoltaic cell according to a fourth embodiment of the invention;
[Fig.5] is a diagram of the different layers of a multi-junction photovoltaic cell according to an embodiment of the invention;
[Fig.6] is a diagram of different manufacturing steps of a tandem photovoltaic cell according to a first embodiment of the invention;
[Fig.7] is a diagram of different manufacturing steps of a tandem photovoltaic cell according to a second embodiment of the invention;
[Fig.8] is a flowchart of different steps of a manufacturing process of a tandem photovoltaic cell according to the first embodiment of the invention;
[Fig.9] is a flowchart of different steps of a manufacturing process of a tandem photovoltaic cell according to the second embodiment of the invention;

### Detailed description of the invention

The present invention refers to a photovoltaic cell comprising a p-n or p-i-n heterojunction, that is to say a junction comprising a first element or alloy to provide the p part of the junction and a second element or alloy to provide the n part of the junction. The difference between the p part of the junction and the n part of the junction is therefore not obtained only by a difference of doping. In the case of a p-i-n junction, the intrinsic part refers to the presence of undoped (intrinsic) sub-layers at the interface between the p-part and the n-part of the junction.

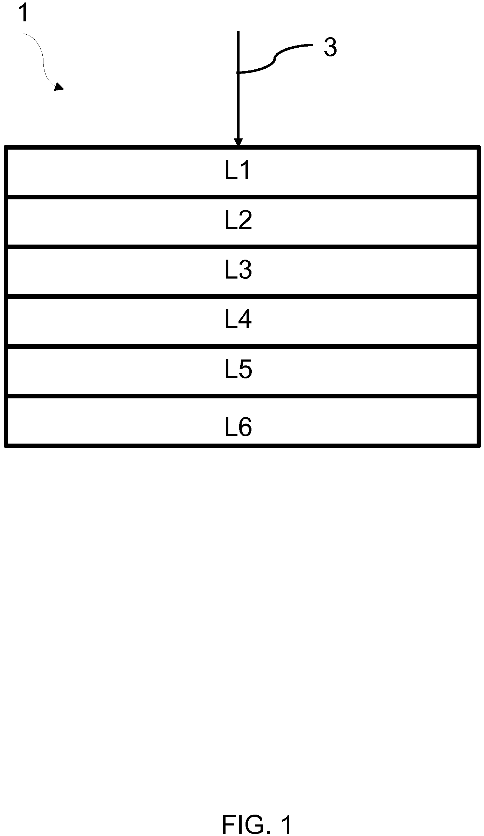

Fig.1 represents a general structure of a photovoltaic cell 1 according to a first embodiment of the present invention. The photovoltaic cell 1 comprises a stack with a plurality of layers:
- a front contact layer L1 comprising a front side corresponding to the side by which the light, represented by the arrow 3, enters the layer L1 and a back side opposed to the front side. The front contact layer L1 enables collecting the current and forming an ohmic contact with a metal grid (not represented in fig.1) disposed on top of the front contact layer L1. The part of the front contact layer L1 which is not under the grid (considering that the photovoltaic cell is arranged so that the different layers lie horizontally (the vertical direction corresponding to the direction of gravity) and a front side of a layer is arranged above a back side of a layer) is removed afterwards by an etching process.
- a window layer L2 comprising a front side in contact with the back side of the front contact layer L1 and a back side opposed to the front side. The window layer L2 is used as a barrier to reduce surface recombination by letting the majority carriers pass (electrons in the case of a n-type layer) to be collected at the front contact layer L1 and by blocking the minority carrier (holes in the case of a n-type layer).
- an emitter layer L3 comprising a front side in contact with the back side of the window layer L2 and a back side opposed to the front side.
- a base layer L4 comprising a front side in contact with the back side of the emitter layer L3 and a back side opposed to the front side.
   The emitter layer L3 and the base layer L4 belongs to the layers wherein the light is absorbed and produces electron-hole pairs. The emitter layer L3 corresponds for example to a n-type layer and the base layer L4 corresponds for example to a p-type layer.
- a back surface field layer L5 comprising a front side in contact with the back side of the base layer L4 and a back side opposed to the front side. The back surface field layer L5 enables reducing the recombination of electrons and holes by creating a bandgap barrier and blocking electrons.
- a back contact layer L6 comprising a front side in contact with the back side of the back surface field layer L5 and a back side opposed to the front side. The back contact layer L6 enables collecting the holes and forming an ohmic contact with a metal contact (not represented in fig.1) disposed at the back of the back contact layer L6.

In the present invention, the base layer L4 is made of an Aluminium and Arsenic based alloy, notably an Aluminium-Gallium-Arsenic (AlGaAs) alloy and the emitter layer L3 is made of an Indium and Phosporus alloy, notably an Indium-Gallium-Phosphorus (InGaP) alloy.

With such configuration of the emitter layer L3-base layer L4, it is possible to adjust the concentration of Aluminium percentage composition in the base layer L4 to obtain the desired bandgap, in the present case a bandgap close to 1.7 eV and to use the emitter layer L3 as a passivation layer of the base layer L4 to prevent oxidation, in particular deep level aluminium-oxygen defects. The thickness of the emitter layer L3 may also be reduced below 100 nm to limit the overall cost linked to the rareness and expensive cost of the Indium material. The thickness of this passivation layer L3 is for example comprised between 20 and 100nm, in particular between 40 and 60 nm, for example 50 nm. Furthermore, the p-n heterojunction enables increasing the absorption band spectrum and therefore the overall efficiency of the photovoltaic cell due to the two different bandgaps provided by the base layer L4 and the emitter layer L3, in the case of an InGaP alloy, the bandgap of the emitter layer is around 1.9 eV.

The base layer L4 may comprise a plurality of sub-layers having different concentration of Aluminium percentage composition. Some of the sub-layers may also be a graded Aluminium based alloy with an Aluminium percentage composition varying in a predetermined range in order to avoid large hops of bandgaps between adjacent layers and therefore limit the carrier drift phenomenon.

Furthermore, a front sub-layer which is in contact with the back side of the emitter layer L3 and the emitter layer L3 itself may be undoped layers, also called intrinsic layers, in order to improve the carrier collection on both sides on the junction.

For example, the base layer L4 may comprise a back sublayer made of AlGaAs with 25% of Aluminium doped with Beryllium or Carbon and a front sub-layer made of an intrinsic graded AlGaAs with a percentage of Aluminium composition varying from 25 to 30%.

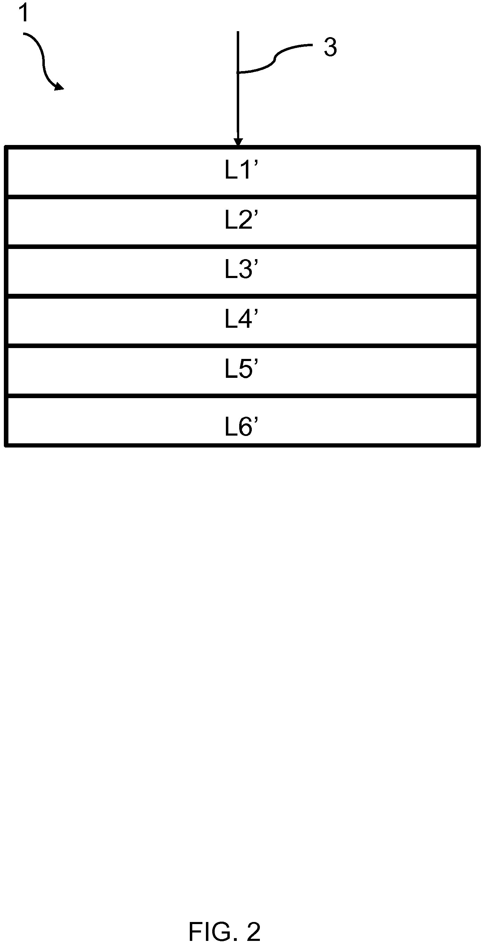

Fig.2 represents an example of a second embodiment of a photovoltaic cell with a heterojunction according to the invention.

The front contact layer L1' is made of Gallium-Arsenic (GaAs) alloy doped with Silicon (Si), Selenium (Se) or Tellurium (Te) with a doping concentration comprised between 5.10¹⁸ cm⁻³ and 5.10¹⁹ cm⁻³, notably between 5.10¹⁸ cm⁻³ and 2.10¹⁹ cm⁻³, for example 1.10¹⁹ cm⁻³. The thickness of the front contact layer L1' may be comprised between 150 and 320 nm, notably between 280 and 320 nm, for example 300 nm.

The window layer L2' is made of Aluminium-Indium-Phosphorus (AlInP) alloy doped with Silicon (Si), Selenium (Se) or Tellurium (Te) with a doping concentration comprised between 5.10¹⁸ cm⁻³ and 2.10¹⁹ cm⁻³, for example 1.10¹⁹ cm⁻³. The thickness of the window layer L2' may be comprised between 20 and 70 nm, notably between 20 and 50 nm, for example 20 nm.

The emitter layer L3' is made of Indium-Gallium-Phosphorus alloy and can be either an intrinsic layer or can be doped with Silicon (Si), Selenium (Se) or Tellurium (Te) with a doping concentration comprised between 1.10¹⁶ cm⁻³ and 2.10¹⁸ cm⁻³. As indicated previously, the emitter layer L3' is preferably an intrinsic layer. The thickness of the window layer L2' may be comprised between 20 and 70 nm, notably between 20 and 100 nm, notably between 40 and 60 nm, for example 50 nm.

The base layer L4' is made of Aluminium-Gallium-Arsenic (AlₓGa₁₋ₓAs) alloy with a percentage of Aluminium composition x comprised in a range from 0 to 0.37, for example 0.25. The AlₓGa₁₋ₓAs alloy may be doped with Beryllium "Be", Carbon "C" or Zinc "Zn" with a doping concentration comprised between 1.10¹⁶ cm⁻³ and 5.10¹⁷ cm⁻³, for example 1.10¹⁹ cm⁻³. The thickness of the base layer L4' may be comprised between 400 and 2000 nm, for example 1000 nm.

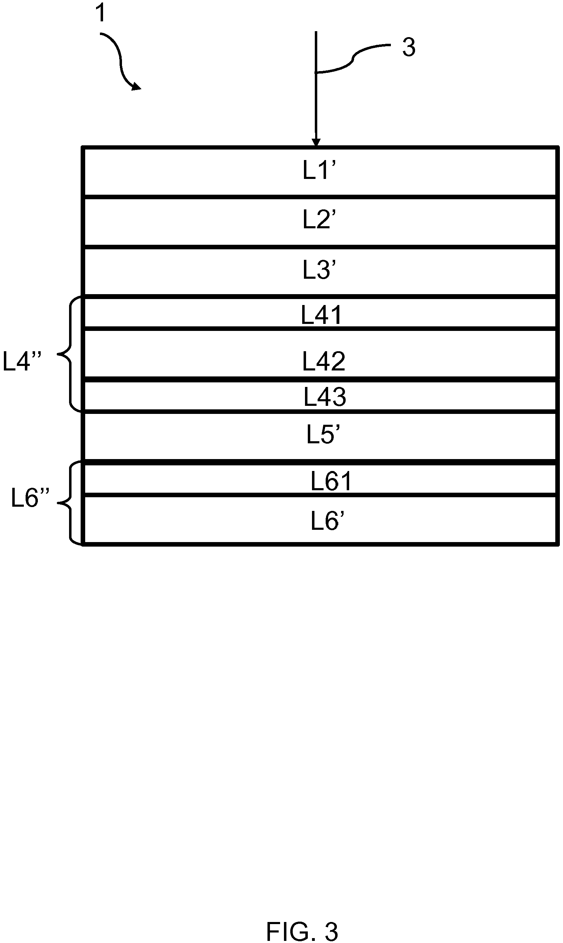

However, as indicated previously with the first embodiment, the base layer L4' may comprise different sub-layers. Fig.3 represents an example of a third embodiment with a base layer L4" comprising three sub-layers: a front sub-layer L41, a main sub-layer L42 and a back sub-layer L43.

The front sub-layer L41 may be an intrinsic layer of graded AlₓGa₁₋ₓAs alloy with a percentage of Aluminium composition x varying from 0.25 to 0.37, for example from 0.25 to 0.3. The front sub-layer L41 may have a thickness comprised between 80 and 120 nm, for example 100 nm. Alternatively, the front sub-layer may be doped, for example with Beryllium. With a doping concentration around 2.10¹⁶.

The main sub-layer L42 may be made of Aluminium-Gallium-Arsenic (AlₓGa₁₋ₓAs) alloy with a percentage of Aluminium composition x of 0.25. The AlₓGa₁₋ₓAs alloy may be doped with Beryllium "Be" with a doping concentration of 2.10¹⁶ cm⁻³. The thickness of the main layer L42 may be comprised between 800 and 1200 nm, for example 1000 nm.

The back sublayer L43 may be made of a graded AlₓGa₁₋ₓAs alloy with a percentage of Aluminium composition x varying from 0.25 to 0.51 The graded AlₓGa₁₋ₓAs alloy may be doped with Beryllium "Be" with a doping concentration of 2.10¹⁶ cm⁻³. The back sub-layer L43 may have a thickness comprised between 80 and 120 nm, for example 100 nm.

The layers L1', L2' and L3' of the photovoltaic cell of fig.3 remain identical to the layers of the photovoltaic cell of fig.2 according to the second embodiment.

The back surface field layer L5' is for example made of Aluminium-Gallium-Arsenic (AlₓGa₁₋ₓAs) alloy with a percentage of Aluminium composition x comprised in a range from 0.4 to 0.8, for example 0.51. The AlₓGa₁₋ₓAs alloy may be doped with Beryllium "Be", Carbon "C" or Zinc "Zn" with a doping concentration comprised between 5.10¹⁸ cm⁻³ and 1.10¹⁹ cm⁻³, for example 5.10¹⁸ cm⁻³. The thickness of the back surface field layer L5' may be comprised between 20 and 120 nm, for example 70 nm.

The back contact layer L6' is for example made of Gallium-Arsenic (GaAs) alloy doped with Beryllium "Be", Carbon "C" or Zinc "Zn" with a doping concentration comprised between 5.10¹⁸ cm⁻³ and 1.10¹⁹ cm⁻³, for example 1.10¹⁹ cm⁻³. The thickness of the back surface field layer L6' may be comprised between 150 and 300 nm, for example 300 nm.

As represented in the third embodiment of fig.3, the back contact layer L6" may also comprise a front additional sub-layer L61 made of Aluminium-Gallium-Arsenic "AlₓGa₁₋ₓAs" with a graded concentration of Aluminium varying between 51% and 0% and doped with Beryllium "Be" with a doping concentration comprised between 4.10¹⁸ cm⁻³ and 6.10¹⁸ cm⁻³ and having a thickness comprised between 80 and 120 nm.

It has to be noted that the composition as well as the different doping concentrations and thicknesses of the different layers may differ from the embodiments described in relationship with Fig.2 and 3 without departing from the scope of the present invention. The number of layers or sub-layers may also differ from the presented embodiments. Furthermore, some layers of an embodiment may be combined with layers of another embodiment to produce a new embodiment.

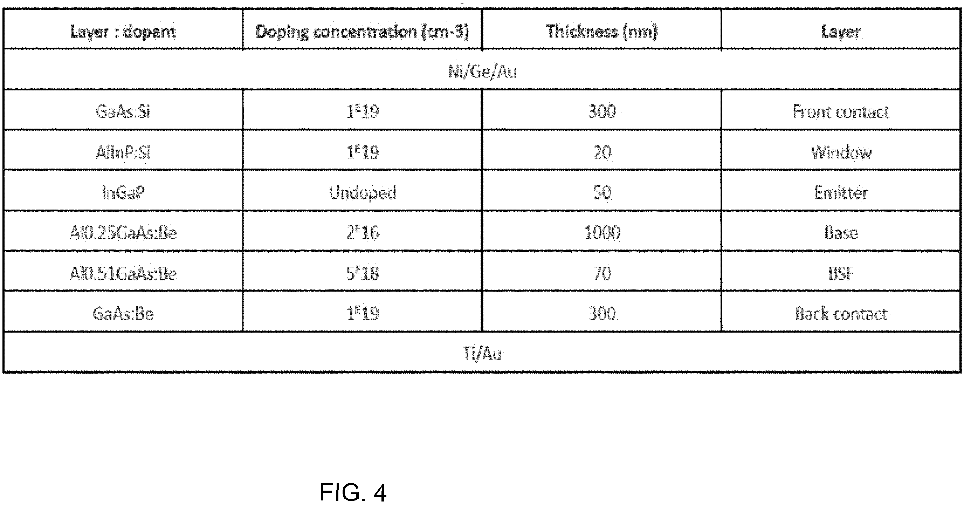

Fig.4 represents a particular embodiment of a photovoltaic cell according to the invention providing a particularly high efficiency. It comprises:
- a front contact layer made of Gallium-µArsenic (GaAs) alloy doped with silicon (Si) with a doping concentration of 1.10¹⁹ and having a thickness of 300 nm,
- a window layer made of Aluminium-Indium-Phosphorus (AlInP) alloy doped with silicon (Si) with a doping concentration of 1.10¹⁹ and having a thickness of 20 nm,
- an emitter layer of intrinsic Indium-Gallium-Phosphorus (InGaP) alloy having a thickness of 50 nm,
- a base layer made of Aluminium-Gallium-Arsenic (AlₓGa₁₋ₓAs) alloy with a percentage of Aluminium composition x of 0.25 doped with Beryllium (Be) with a doping concentration of 2.10¹⁶ and having a thickness of 1000 nm,
- a back surface field layer made of Aluminium-Gallium-Arsenic (AlₓGa₁₋ₓAs) alloy with a percentage of Aluminium composition x of 0.51 doped with Beryllium (Be) with a doping concentration of 5.10¹⁸ and having a thickness of 70 nm,
- a back contact layer made of Gallium-Arsenic (GaAs) alloy doped with Beryllium (Be) with a doping concentration of 1.10¹⁹ and having a thickness of 300 nm.

Furthermore, it has to be noted that the photovoltaic cell generally comprise also metal contacts disposed on the front contact layer L1, L1' and on the back contact layer L6, L6'. The front metal contact may be made of an alloy comprising at least one of the following elements: Nickel (Ni), Germanium (Ge) and/or gold (Au) and may be provided as a grid. The back metal contact may be made of an alloy of at least one of the following elements: Titanium (Ti) and/or gold (Au).

Other metals may also be used for the front and back metal contacts.

The flexibility of the Aluminium-Arsenic based alloys depending on the percentage of Aluminium composition enables therefore obtaining the desired bandgap for this layer and the combination with an emitter made thin layer of Indium-Phosphorus alloys enables preventing the oxydation of the Aluminium-Arsenic alloys of the base layer thus providing a passivation for the base layer and reducing surface recombination.

Moreover, a photovoltaic cell as presented based on fig.2 to 4 is well suited to be used in a multijunction photovoltaic cell or multijunction solar cell comprising a plurality of p-n junctions or p-i-n junctions, in particular as a top cell.

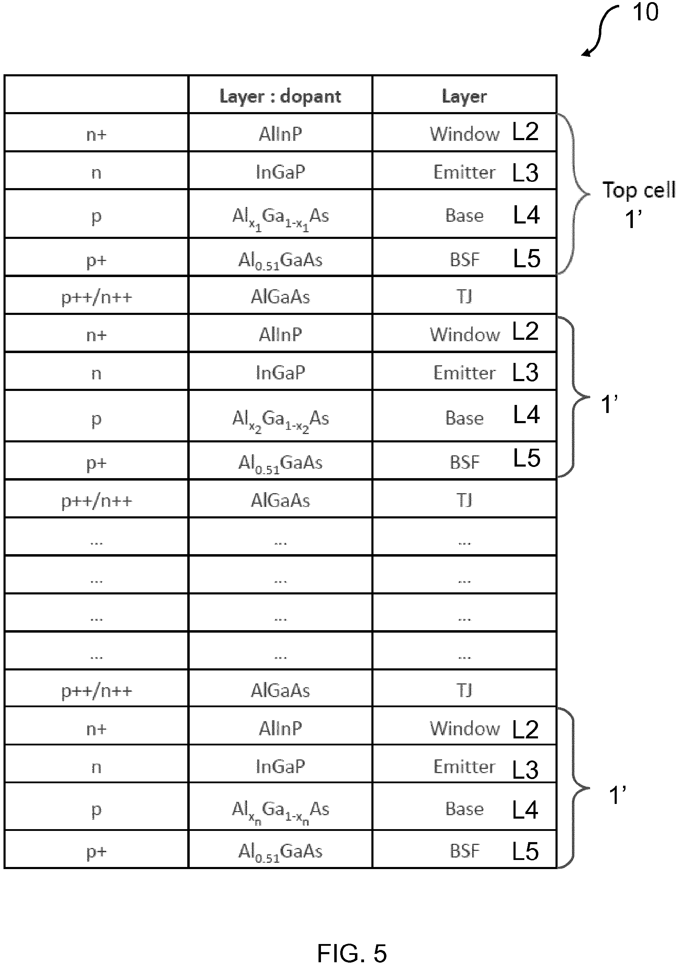

Fig.5 represents an example of a multijunction solar cell 10 comprising a plurality of sub-cells 1'.

The different sub-cells 1' comprise a window layer (made of AlInP alloy) L2 and an emitter layer (made of InGaP alloy) L3 corresponding to the n-part of the junction and a base layer (made of AlGaAs alloy) L4 and a back surface field (made of AlGaAs alloy) L5 corresponding to the p-part.

Two adjacent sub-cells 1' are separated by a tunnel junction (made for example of two layers of AlGaAs alloy, one layer having an n-type doping and the other layer a p-type doping).

The different sub-cells 1' may be identical except for the percentage of Aluminium composition in the base layer. This percentage may vary from 0.37 for the top sub-cell to 0 for the back sub-cell, this percentage being different for each sub-cell and being decreasing from the top sub-cell toward the back sub-cell.

Furthermore, the composition of the tunnel junctions may be adapted to match the bandgap and the doping profile.

A photovoltaic cell as presented based on fig.2 to 4 is also well suited to be used in tandem photovoltaic cell or tandem solar cell comprising a Silicon (Si)-based back cell. The Si-based back sub-cell has for example a bandgap around 1.1 eV.

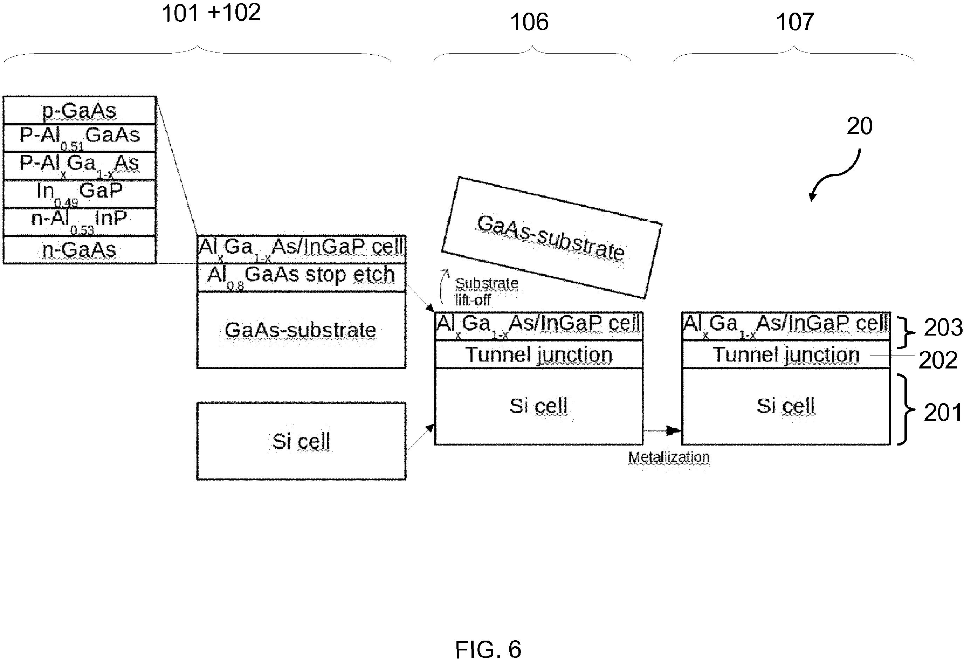

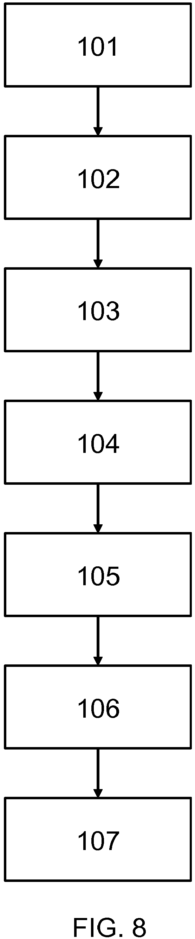

Fig.6 represents a first embodiment of a tandem photovoltaic cell 20 in the case of a two terminal (2T) photovoltaic cell at different steps of the manufacturing process. It comprises a back sub-cell 201 in a form of a homojunction (Si) with a metallic back contact, a tunnel junction 202 and front sub-cell 203 with a heterojunction (AlGaAs/InGaP) with a metallic front contact. The manufacturing steps will be described in more details in the following of the description based on Fig.8.

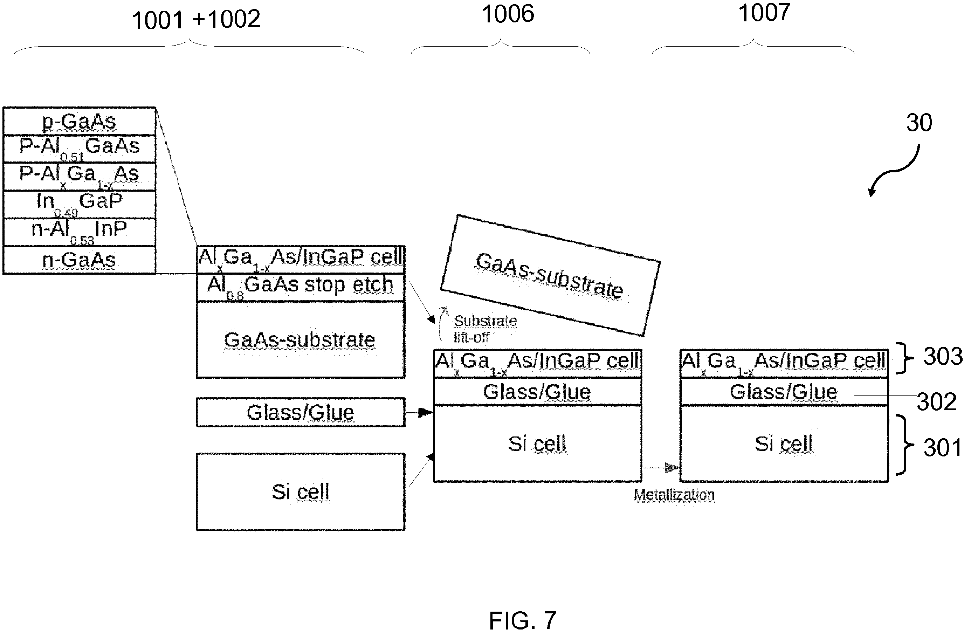

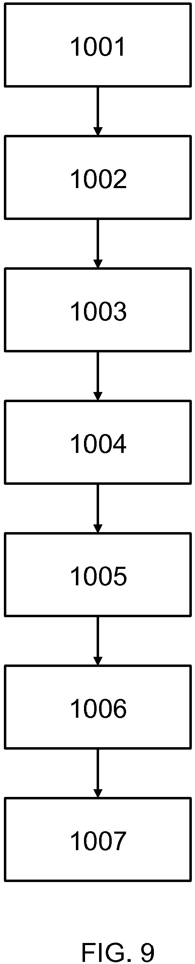

Fig.7 represents a second embodiment of a tandem photovoltaic cell in the case of a four terminal (4T) photovoltaic cell at different steps of the manufacturing process. It comprises a back sub-cell 301 in form of a homojunction (Si) with a metallic back contact, a first internal contact on the front side of the Si sub-cell, a transparent insulated (electrically) intermediate layer 302, for example a glass layer, a second internal contact on the front side of the intermediate layer, and a front sub-cell 303 comprising a heterojunction (AlGaAs/InGaP) with a metallic front contact. The manufacturing steps will be described in more details in the following of the description based on Fig.9.

It is also possible to combine the embodiment of fig.5 with the embodiment of Fig.6 or 7 to provide a multijunction cell with a plurality of sub-cells as described in fig.5 combined with a back Si sub-cell as disclosed in fig.6 or 7.

Such tandem photovoltaic comprising on a front side at least one heterojunction (AlGaAs/InGaP) sub-cell having a bandgap around 1.7 eV and on the back side a homojunction Si sub-cell having a bandgap around 1.1 eV enables the absorption by the different junctions of a wide spectrum of light wavelengths and a limited carrier recombination leading therefore to a high efficiency. Furthermore, the use of only a thin layer of Indium-Phosphorus based alloy enables limiting the global cost while avoiding deep level oxidation.

The present invention also refers to a manufacturing process to obtain a photovoltaic cell, multijunction photovoltaic cell or tandem photovoltaic cell according to one of the embodiments described previously.

According to a first embodiment of the manufacturing process, different layers of the heterojunction photovoltaic cell are obtained by a Molecular Beam Epitaxy (MBE).

According to a second embodiment of the manufacturing process, different layers of the heterojunction photovoltaic cell are obtained by a Metalorganic Chemical Vapor Deposition (MCVD).

The manufacturing process may also comprise additional steps such as bonding steps, etching steps, or metallization steps for example.

The different steps for manufacturing a tandem photovoltaic cell combining a silicon based sub-cell and a AlGaAs/InGaP based heterojunction will now be described based on the flowcharts of Fig.8 in combination with fig.6 and Fig.9 in combination with fig.7.

Fig.8 corresponds to a manufacturing process based on a bonding technique to obtain a two terminal (2T) tandem cell whereas Fig.9 corresponds to a manufacturing process based on a mechanical stacking technique to obtain a four terminal (4T) tandem cell.

### a) 2T tandem cell manufacturing

In fig. 8, the first step 101 refers to the growth process to obtain the different layers of the Si-based photovoltaic sub-cell. As indicated previously, the different layers of the Si-based photovoltaic cell may be grown based on chemical vapor deposition (CVD) or other deposition techniques.

The second step 102 refers to the growing process to obtain the different layers of the AlGaAs/InGaP based heterojunction. As indicated previously, the different layers of the AlGaAs/InGaP based heterojunction may be grown based on a Molecular Beam Epitaxy (MBE) process or a Metalorganic Chemical Vapor Deposition (MOCVD).

This second step 102 may be achieved before or simultaneously with the step 101. Both steps are represented on the left part of Fig.6.

The third step 103 corresponds to the growth process of the tunnel junction. This growing process may be achieving on the Si-based photovoltaic cell or on the AlGaAs/InGaP based heterojunction or partially on both. The same growth process as for steps 101 and 102 can be used.

The fourth step 104 refers to a polishing step to obtain smooth surfaces in order to allow a reliable bonding.

The fifth step 105 refers to a bonding step wherein the smooth surfaces that need to be bonded are pressed against each other and are heated to produce surfaces fusion and bonding.

Different techniques may be used to obtain such bonding, for example ion implantation, direct fusion by electrical conductive layers and high temperature up to 300°C, surface activated direct wafer bonding at low temperature (100°C) or direct metal interconnection.

The sixth step 106 refers to a substrate lift-off. The substrate is generally a GaAs based substrate which is used for the growth process of step 102 and can be removed. This step is represented in the middle part of Fig.6

The seventh step 107 refers to the finalization step comprising other required tasks to obtain the tandem photovoltaic and notably the possible etching step of the front contact layer L1 or the metallization step to obtain the front and back metal contacts as represented in the right part of Fig.6.

### a) 4T tandem cell manufacturing

In fig. 9, the first 1001 and second 1002 steps are identical to the bonding process described based on Fig.8. The left part of fig.7 represents these steps 1001 and 1002 which can be achieved simultaneously or in any order.

The third step 1003 corresponds to the finalization step of the two photovoltaic cells comprising an etching step, for example to remove parts of the front contact layer L1 and a metallization step to obtain the intermediate metal contacts located at the back of the AlGaAs/InGaP based heterojunction and at the front of the Si-based sub-cell.

The fourth step 1004 refers to the applying of epoxy or non-conductive glue on the surfaces to be glued. A glass layer may also be used to ensure the electrical insulation between both sub-cells.

The fifth step 1005 refers to a gluing step wherein the surfaces to be glued are pressed against each other. Heating may be used if the epoxy needs heat to be hardened. Heating may be limited to 200°C to avoid damaging the sub-cells.

The sixth step 1006 refers to a substrate lift-off. The substrate is generally a GaAs based substrate which is used for the growth process of step 102 and can be removed. The middle part of Fig.7 represent this sixth step 1006.

The seventh step 1007 refers to the finalization step comprising other required tasks to obtain the tandem photovoltaic and notably the possible etching step of the front contact layer L1 or the metallization step to obtain the front and back metal contacts as represented in the right part of Fig.7.

Thus, the present invention allows obtaining efficient tandem photovoltaic cells with a high efficiency and a limited global cost.

## Claims

1. Photovoltaic cell (1) comprising a heterojunction with a base layer (L4, L4', L4") made from an Aluminium-Arsenic-based alloy and an emitter layer (L3, L3') made from an Indium-Phosphorous based alloy wherein the emitter layer (L3, L3') has a thickness smaller than 100 nm and acts as a passivation layer to prevent oxidation of the base layer and reduce surface recombination (L4, L4', L4").

2. Photovoltaic cell (1) in accordance with claim 1 wherein the heterojunction is a p-i-n heterojunction and comprises at least one intrinsic sub-layer at the interface between the base layer (L4, L4', L4") and the emitter layer (L3, L3').

3. Photovoltaic cell (1) in accordance with claim 1 or 2 wherein the base layer (L4, L4', L4") is made of an Aluminium-Gallium-Arsenic "AlGaAs" alloy.

4. Photovoltaic cell (1) in accordance with one of the previous claims wherein the emitter layer (L3, L3') is made of an Indium-Gallium-Phosphide "InGaP" alloy.

5. Photovoltaic cell in accordance with one of the previous claims wherein the base layer (L4") comprises a graded Aluminium based alloy with an Aluminium percentage composition varying in a range from 20 to 55%.

6. Photovoltaic cell (1) in accordance with claim 5 wherein the base layer (L4") comprises a first sublayer made of AlGaAs with 25% of Aluminium doped with Beryllium and a second sub-layer made of an intrinsic graded AlGaAs with a percentage of Aluminium composition varying from 25 to 30%.

7. Photovoltaic cell (1) in accordance with one of the previous claims wherein the base layer (L4, L4', L4") has a bandgap of 1.7 eV and the emitter layer has a bandgap of 1.9 eV.

8. Photovoltaic cell (1) in accordance with one of the previous claims wherein it comprises:
- a front contact layer (L1, L1') made of Gallium-Arsenic "GaAs" alloy doped with one among the following dopants:
- Silicon "Si",
- Selenium "Se",
- Tellurium "Te",
with a doping concentration comprised between 5.10¹⁸ cm⁻³ and 5.10¹⁹ cm⁻³
and having a thickness comprised between 150 nm and 300 nm,
- a window layer (L2, L2') made of Aluminium-Indium-Phosphide "AlInP" alloy doped with one among the following dopants:
- Silicon "Si",
- Selenium "Se",
- Tellurium "Te",
with a doping concentration comprised between 5.10¹⁸ cm⁻³ and 1.10¹⁹ cm⁻³
and having a thickness comprised between 20 nm and 70 nm,
- an emitter layer (L3, L3') made of Indium-Gallium-Phosphide "InGaP" alloy which can be doped with one among the following dopants:
- Silicon "Si",
- Selenium "Se",
- Tellurium "Te",
with a doping concentration comprised between 1.10¹⁶ cm⁻³ and 2.10¹⁸ cm⁻³
and having a thickness comprised between 20 nm and 100 nm,
- a base layer (L4, L4', L4") made of Aluminium-Gallium-Arsenic "AlₓGa₁₋ₓAs" alloy with x comprised between 0 and 0.37 and doped with one among the following dopants:
- Beryllium "Be",
- Carbon "C",
- Zinc "Zn",
with a doping concentration comprised between 2.10¹⁶ cm⁻³ and 5.10¹⁷ cm⁻³
and having a thickness comprised between 200 nm and 2000 nm,
- a back surface field (L5, L5') made of Aluminium-Gallium-Arsenic "AlₓGa₁₋ₓAs" alloy with x comprised between 0.4 and 0.8 and doped with one among the following dopants:
- Beryllium "Be",
- Carbon "C",
- Zinc "Zn",
with a doping concentration comprised between 5.10¹⁸ cm⁻³ and 1.10¹⁹ cm⁻³
and having a thickness comprised between 20 nm and 120 nm,
- a back contact layer (L6, L6') made of Gallium-Arsenic "GaAs" alloy doped with one among the following dopants:
- Beryllium "Be",
- Carbon "C",
- Zinc "Zn",
with a doping concentration comprised between 5.10¹⁸ cm⁻³ and 1.10¹⁹ cm⁻³
and having a thickness comprised between 150 nm and 300 nm.

9. Photovoltaic cell (1) in accordance with one of the previous claims wherein it comprises:
- a front contact layer (L1) made of Gallium-Arsenic "GaAs" alloy doped with Silicon "Si"
with a doping concentration comprised between 5.10¹⁸ cm⁻³ and 2.10¹⁹ cm⁻³ and having a thickness comprised between 150 and 320 nm,
- a window layer (L2) made of Aluminium-Indium-Phosphide "AlInP" alloy doped with Silicon "Si" with a doping concentration comprised between 5.10¹⁸ cm⁻³ and 2.10¹⁹ cm⁻³
and having a thickness comprised between 20 nm and 50 nm,
- an undoped emitter layer (L3) made of Indium-Gallium-Phosphide "InGaP" having a thickness comprised between 40 and 60 nm,
- a base layer (L4) made of Aluminium-Gallium-Arsenic "Al_{0.25}GaAs" alloy doped with Beryllium "Be" with a doping concentration comprised between 1.10¹⁶ cm⁻³ and 2.10¹⁷ cm⁻³
and having a thickness comprised between 400 nm and 2000 nm,
- a back surface field (L5) made of Aluminium-Gallium-Arsenic "Al_{0.51}GaAs" alloy doped with Beryllium "Be" with a doping concentration comprised between 4.10¹⁸ cm⁻³ and 1.10¹⁹ cm⁻³
and having a thickness comprised between 20 nm and 80 nm,
- a back contact layer (L6) made of Gallium-Arsenic "GaAs" alloy doped with Beryllium "Be", with a doping concentration comprised between 5.10¹⁸ cm⁻³ and 2.10¹⁹ cm⁻³
and having a thickness comprised between 150 nm and 300 nm.

10. Photovoltaic cell (1) in accordance with claim 8 or 9 wherein the base layer (L4, L4") also comprises:
- a front additional sub-layer (L41) made of undoped Aluminium-Gallium-Arsenic "AlₓGa₁₋ₓAs" with a graded concentration of Aluminium varying between 25% and 37% and having a thickness comprised between 80 and 120 nm,
- a back additional sub-layer (L43) made of Aluminium-Gallium-Arsenic "AlₓGa₁₋ₓAs" with a graded concentration of Aluminium varying between 25% and 51% and doped with Beryllium "Be" with a doping concentration comprised between 4.10¹⁸ cm⁻³ and 6.10¹⁸ cm⁻³ and having a thickness comprised between 80 and 120 nm.

11. Photovoltaic cell (1) in accordance with claim 9 or 10 wherein the back contact layer (L6, L6") also comprises:
- a front additional sub-layer (L61) made of Aluminium-Gallium-Arsenic "AlₓGa₁₋ₓAs" with a graded concentration of Aluminium varying between 51% and 0% and doped with Beryllium "Be" with a doping concentration comprised between 4.10¹⁸ cm⁻³ and 6.10¹⁸ cm⁻³ and having a thickness comprised between 80 and 120 nm.

12. Multi-junction photovoltaic cell (10, 20, 30) comprising a stack of at least a first and a second photovoltaic cells, with a front photovoltaic cell having a first bandgap and a second photovoltaic cell having a second bandgap lower than the first bandgap wherein at least the front photovoltaic cell is a photovoltaic cell in accordance with one of the previous claims.

13. Multi-junction photovoltaic cell (20, 30) in accordance with claim 12 comprising two photovoltaic cells wherein the second photovoltaic cell is a silicon-based cell having a bandgap of 1.1 eV.

14. Method for manufacturing a photovoltaic cell or a tandem photovoltaic cell in accordance with one of the previous claims wherein at least some of the layers of the tandem photovoltaic cell are obtained based on a molecular beam epitaxy "MBE" process or a Metalorganic Chemical Vapor Deposition "MOCVD" process.
